# EUROPÄISCHE PATENTSCHRIFT

(11) **EP 1 299 898 B1**
(45) Veröffentlichungstag und Bekanntmachung des Hinweises auf die Patenterteilung: **14.11.2007**
(21) Anmeldenummer: 01956509.2
(22) Anmeldetag: 03.07.2001
(51) Int. Cl.: H01J 37/28, H01J 37/18, F04D 19/04

(54) **TEILCHENSTRAHLGERÄT MIT EINER IM ULTRAHOCHVAKUUM ZU BETREIBENDEN TEILCHENQUELLE UND KASKADENFÖRMIGE PUMPANORDNUNG FÜR EIN SOLCHES TEILCHENSTRAHLGERÄT**
PARTICLE RADIATION DEVICE COMPRISING A PARTICLE SOURCE THAT IS OPERATED IN AN ULTRAHIGH VACUUM AND A CASCADE PUMP ASSEMBLY FOR A PARTICLE RADIATION DEVICE OF THIS TYPE
APPAREIL A FAISCEAU DE PARTICULES COMPRENANT UNE SOURCE DE PARTICULES DEVANT FONCTIONNER SOUS ULTRAVIDE ET DISPOSITIF DE POMPE EN FORME DE CASCADE, DESTINE A UN TEL APPAREIL A FAISCEAU DE PARTICULES

(30) Priorität: 07.07.2000 DE 10032607
(43) Veröffentlichungstag der Anmeldung: 09.04.2003
(73) Patentinhaber: Carl Zeiss NTS GmbH, 73446 Oberkochen (DE)
(72) Erfinder: GNAUCK, Peter, 72764 Reutlingen (DE); DREXEL, Volker, 89551 Königsbronn (DE)
(74) Vertreter: Gnatzig, Klaus
(86) Internationale Anmeldenummer: PCT/EP2001/007597
(87) Internationale Veröffentlichungsnummer: WO 2002/005310

(56) Entgegenhaltungen:
- EP-A- 0 643 227
- WO-A-00/46508
- US-A- 4 651 171
- US-A- 5 733 104
- US-A- 5 828 064
- US-A- 6 030 189

## Beschreibung

Die vorliegende Erfindung betrifft ein Teilchenstrahlgerät mit einer im Ultrahochvakuum zu betreibenden Teilchenquelle sowie eine kaskadenförmige Pumpanordnung für ein entsprechendes Teilchenstrahlgerät.

In der US 5 828 064 ist ein sogenanntes Environmental Scanning Elektronenmikroskop (ESEM) mit einer Feldemissionsquelle beschrieben. Derartige ESEM's erlauben die elektronenmikroskopische Untersuchung von Proben unter normalem Atmosphärendruck oder gegenüber dem normalen Atmosphärendruck nur geringfügig reduziertem Druck. Da andererseits Feldemissionsquellen und auch die häufig als Feldemissionsquellen bezeichneten sogenannten Schottky-Emitter für ihren Betrieb ein Ultrahochvakuum benötigen, ist das gesamte Elektronenmikroskop als differentiell gepumptes System mit drei Zwischendruckstufen aufgebaut. Das Gesamtsystem weist demzufolge fünf Druckbereiche auf, die durch vier Druckstufen oder Druckstufenblenden voneinander getrennt sind. Neben dem Aufwand für die Pumpen resultiert aus dem für die Vakuumanschlüsse der drei Zwischendruckbereiche benötigten Bauraum ein zusätzlicher Bedarf an Bauhöhe, wie dieser allein für die elektronenoptischen Komponenten nicht erforderlich wäre.

Aus der US 4 720 633-A ist ein weiteres ESEM bekannt, bei dem jedoch das Vakuum in der Kammer der Elektronenquelle zu schlecht ist, um das Gerät mit einer Feldemissionsquelle zu betreiben.

Aus der US 5 717 204-A ist ein Elektronenmikroskop für die Inspektion in der Halbleiterfertigung bekannt, bei dem der Ultrahochvakuuumbereich und der dem Ultrahochvakuumbereich benachbarte Zwischendruckbereich durch Ionengetterpumpen evakuiert ist; die Probenkammer und der zur Probenkammer benachbarte Druckbereich sind jeweils durch eine separate Turbomolekularpumpe gepumpt, wobei die beiden Turbomolekularpumpen an die Ansaugseite einer gemeinsamen Vorpumpe angeschlossen sind. Derartige Inspektionsgeräte sind üblicher Weise nicht zum Betrieb mit einem schlechten Vakuum in der Probenkammer konzipiert.

Aus der DE 43 31 589-A1 ist eine kaskadenförmige Pumpanordnung mit hinter einander geschalteten Turbomolekularpumpen bekannt, bei der jeweils der Auslaß einer Turbomolekularpumpe durch den Main Port einer vorgeschalteten Turbomolekularpumpe vorgepumpt ist, wobei die Ansaugseite der vorgeschalteten Turbomolekularpumpe über ein T-Stück gleichzeitig an einen Zwischendruckbereich angeschlossen ist. Durch diese kaskadenförmige Pumpanordnung wird das Vakuum in dem von der vorgeschalteten Turbomolekularpumpe gepumpten Zwischendruckbereich durch den Gasstrom der nächst höheren Vakuumstufe belastet.

Aus der US 4 889 995-A ist ein Rasterelektronenmikroskop bekannt, bei dem eine von einer Rotationspumpe vorgepumpte Turbomolekularpumpe parallel über Ventile sowohl zum Evakuieren der Präparatkammer als auch der Kammer der Elektronenquelle und der Zwischendruckbereiche dient. Zusätzlich sind zur Evakuierung der Kammer der Elektronenquelle und der beiden benachbarten Zwischendruckbereiche Ultrahochvakuumpumpen vorgesehen. Mit einer solchen Pumpenanordnung ist ebenfalls ein Betrieb mit schlechtem Vakuum in der Probenkammer nicht möglich.

Aus einem Aufsatz in Japan. J. Appl. Phys. Suppl 2, S 249 ff, (1974) ist ein Elektronenmikroskop mit einer Pumpenanordnung aus ÖL-Diffusionspumpen bekannt. Öldiffusionspumpen sind jedoch wegen ihrer geringen Pumpkapazität bei hohen Drücken ungeeignet für Elektronenmikroskope, bei denen die Präparatkammer mit variierenden Drücken betreibbar sein soll.

Ziel der vorliegenden Erfindung ist es, ein Korpuskularstrahlgerät, insbesondere ein Rasterelektronenmikroskop anzugeben, das trotz variablem Druck in der Probenkammer bis hin zu nahezu Umgebungsdruck und Ultrahochvakuum im Bereich der Teilchenquelle einen vereinfachten Aufbau aufweist. Ein weiteres Ziel der vorliegenden Erfindung ist es, ein Vakuumpumpsystem anzugeben, mit dem ein entsprechend vereinfachter Aufbau eines Korpuskularstrahlgerätes ermöglicht wird.

Diese Ziele werden erfindungsgemäß durch eine Pumpenanordnung mit den Merkmalen des Anspruches 1 und ein Teilchenstrahlgerät mit den Merkmalen des Anspruches 4 erreicht.

Eine erfindungsgemäße kaskadenförmige Pumpenanordnung für ein Teilchenstrahlgerät weist zwei Turbomolekularpumpen auf, von denen die zweite Turbomolekularpumpe zum Vorpumpen des Ausganges der ersten Turbomolekularpumpe dient, wobei der Auslaß der zweiten Turbomolekularpumpe an einen zwischen dem Haupt-Pumpenport und dem Auslaß liegenden Zwischendruckbereich der ersten Turbomolekularpumpe angeschlossen ist.

Die erste Turbomolekularpumpe kann dabei eine sogenannte Split-Flow Pumpe sein, die einen zusätzlichen Pumpenport aufweist, der im Bereich der Drag-Stufe der Turbomolekularpumpe liegt. Dieser Drag-Stufen Pumpenport wird dann vorzugsweise zum vorpumpen der zweiten Turbomolekularpumpe verwendet.

Als Drag-Stufe wird dabei üblicher Weise eine in Turbomolekularpumpen häufig eingesetzte Anordnung aus um einen Stator rotierenden Scheiben mit einer Erhöhung und einem Loch im Randbereich bezeichnet, die ausgangsseitig des letzten Rotorblattes der Turbomolekularpumpe angeordnet ist und zur zusätzlichen Kompression des gepumpten Gases dienen.

Das Vorpumpen einer Turbomolekularpumpe durch das Vorvakuum eines Zwischendruckbereich, z.B. des Drag-Stufen Pumpenports, einer vorpumpenden Turbomolekularpumpe liefert den Vorteil, daß der Bereich des Haupt-Pumpenports nicht durch den Gasfluß der vorgepumpten Turbomolekularpumpe belastet wird. Dadurch läßt sich trotz der Doppelfunktion der vorpumpenden Turbomolekularpumpe ein besseres Vakuum in dem vom Haupt-Pumpenport evakuierten Bereich erzielen.

Das Teilchenstrahlgerät mit einer entsprechenden kaskadenförmigen Pumpanordnung weist eine im Ultrahochvakuum zu betreibende Teilchenquelle und eine Präparatkammer auf, die mit Drücken vom Hochvakuumbereich mit Drücken unter 10⁻³ hPa bis mindestens 1 hPa (Hektopascal) betreibbar ist. Zwischen dem Ultrahochvakuumbereich der Teilchenquelle und der Probenkammer sind beim erfindungsgemäßen Teilchenstrahlgerät genau zwei weitere Druckbereiche vorgesehen.

Das Teilchenstrahlgerät weist demgemäß genau vier Druckbereiche auf, nämlich den Ultrahochvakuumbereich, in dem die Teilchenquelle angeordnet ist, zwei Zwischendruckbereiche und die Präparatkammer. Insgesamt ergeben sich damit beim erfindungsgemäßen Teilchenstrahlgerät drei Druckstufen, für die drei Druckstufenblenden insgesamt erforderlich sind.

Um mit nur drei Druckstufen auszukommen, ist der dem Ultrahochvakuumbereich benachbarte Druckbereich über eine Turbomolekularpumpe gepumpt. Weiterhin ist der Auslaß dieser Turbomolekularpumpe durch eine vorgeschaltete Turbomolekularpumpe vorgepumpt, wobei der Auslaß der Turbomolekularpumpe an die Drag-Stufe der vorgeschalteten Turbomolekularpumpe angeschlossen ist. Durch diese Pumpenanordnung wird der Druck in dem dem Ultrahochvakuumbereich benachbarten Druckbereich auf Werte größer 10⁻⁶ hPa gehalten.

Bei einem weiterhin vorteilhaften Ausführungsbeispiel ist der Haupt-Pumpenport der ersten Turbomolekularpumpe an den der Probenkammer benachbarten Druckbereich angeschlossen ist. Die erste Turbomolekularpumpe kann dadurch eine Doppelfunktion erfüllen, nämlich gleichzeitig den Auslaß der zweiten Turbomolekularpumpe vorpumpen und außerdem den der Probenkammer benachbarten Druckbereich evakuieren.

Weiterhin vorzugsweise ist eine Vorpumpe vorgesehen, durch die der Auslaß der ersten Turbomolekularpumpe vorgepumpt ist. Diese Vorpumpe kann zusätzlich dazu dienen, die Präparatkammer auf den gewünschten Druck zu evakuieren. Soweit das Teilchenstrahlgerät auch bei Drücken oberhalb 5 hPa in der Probenkammer betreibbar sein soll, empfiehlt sich jedoch eine zweite Vorpumpe zur Evakuierung der Präparatkammer vorzusehen, so daß die erste Vorpumpe ausschließlich den Auslaß der ersten Turbomolekularpumpe vorpumpt.

Nachfolgend werden Einzelheiten der Erfindung anhand der in den Figuren beschriebenen Ausführungsbeispiele näher erläutert. Im einzelnen zeigen:
- Figur 1:: Eine Prinzipskizze eines ersten Ausführungsbeispiels der Erfindung für geringere Kammerdrücke und
- Figur 2:: eine Prinzipskizze eines zweiten Ausführungsbeispiels der Erfindung für höhere Kammerdrücke.

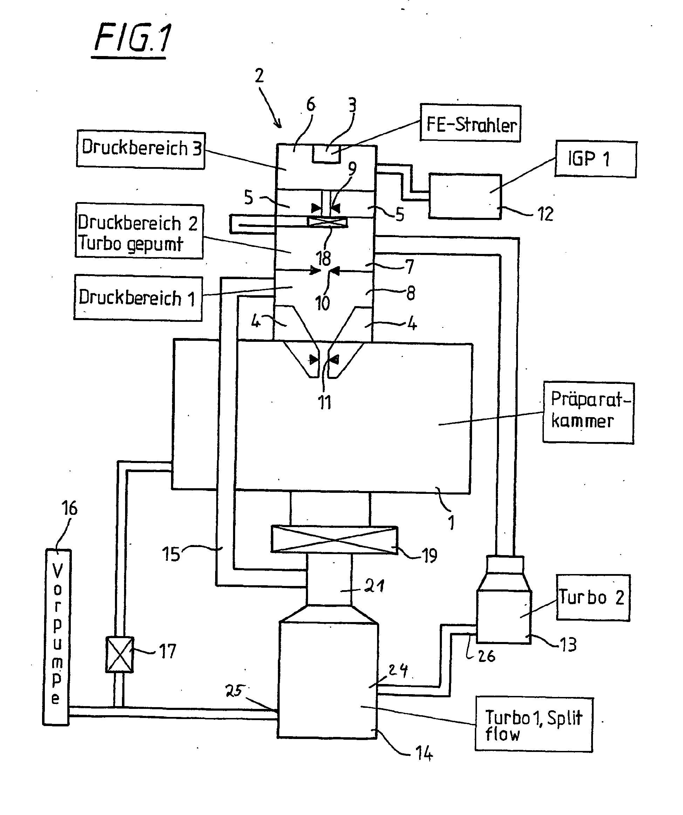

In der Figur 1 ist mit (1) die Präparatkammer und mit (2) die elektronenoptische Säule des Teilchenstrahlgerätes bezeichnet. Die elektronenoptische Säule (2) weist drei Druckbereiche (6), (7), (8) auf, die jeweils durch Druckstufenblenden (9), (10), (11) voneinander getrennt sind. Der - geometrisch gesehen - oberste Druckbereich (6) der elektronenoptischen Säule (2) ist für die Aufrechterhaltung eines Ultrahochvakuums mit einem Druck kleiner 5 x 10⁻⁸ hPa ausgelegt. Dieser Ultrahochvakuumbereich wird über eine Ionengetterpumpe (12) evakuiert. In diesem Ultrahochvakuumbereich ist die Teilchenquelle (3) in Form einer Feldemissionsquelle bzw. eines Schottky-Emitters angeordnet.

Zwischen dem Ultrahochvakuumbereich (6) und dem zu diesem benachbarten Zwischendruckbereich (7) ist der Kondensor (5) des Teilchenstrahlgerätes angeordnet, von dem in der Figur 1 nur die Polschuhe angedeutet sind. Etwa in Höhe des oder - in Ausbreitungsrichtung der Elektronen gesehen - hinter dem Polschuhspalt der Kondensorlinse (5) ist die Druckstufenblende (9) angeordnet, die für die Aufrechterhaltung eines geeigneten Druckunterschiedes zwischen dem Ultrahochvakuumbereich (6) und dem zu diesem benachbarten Zwischendruckbereich (7) gewährleistet.

Auf den ersten Zwischendruckbereich (7) folgt ein zweiter Zwischendruckbereich (8), der von dem ersten Zwischendruckbereich (7) durch eine zweite Druckstufenblende (10) getrennt ist. Zwischen diesem zweiten Zwischendruckbereich (8) und der Präparatkammer ist die Objektivlinse (4) des Teilchenstrahlgerätes angeordnet, von der in der Figur 1 ebenfalls nur die Polschuhe angedeutet sind. Zwischen oder - in Ausbreitungsrichtung der Elektronen gesehen - vor den Polschuhen der Objektivlinse (4) ist die dritte Druckstufenblende (11) angeordnet, die einen geeigneten Druckunterschied zwischen dem zweiten Zwischendruckbereich (8) und der Präparatkammer (1) sicherstellt.

Für die Einstellung geeigneter Vakuumbedingungen ist beim Ausführungsbeispiel der Figur 1 neben der Ionengetterpumpe (12) für den Ultrahochvakuumbereich (6) eine kaskadenförmige Pumpanordnung aus einer Vorpumpe (16) und zwei teilweise ebenfalls seriell geschalteten Turbomolekularpumpen (13), (14) vorgesehen. Die Vorpumpe (16) erfüllt dabei eine Doppelfunktion. Die Vorpumpe (16) dient einerseits zum Evakuieren der Präparatkammer (1) direkt über eine separate Rohrverbindung und gleichzeitig zum Abpumpen des Ausganges (25) der ersten Turbomolekularpumpe (14). Die Evakuierung der Präparatkammer (1) ist dabei über ein Ventil (17) in der Rohrverbindung regelbar. Der Druck in der Präparatkammer ist über ein nicht dargestelltes, regelbares Gaseinlaßventil einstellbar.

Die erste Turbomolekularpumpe (14) ist als leistungsstarke sogenannte Split-Flow-Pumpe ausgelegt und erfüllt eine Dreifachfunktion. Der Ansaugstutzen des Haupt-Pumpenports (21) ist über eine Rohrleitung (15) direkt an den zur Präparatkammer (1) benachbarten Zwischendruckbereich (8) angeflanscht und sorgt dadurch für eine direkte Evakuierung dieses Zwischendruckbereiches. Gleichzeitig ist der Ansaugstutzen des Haupt-Pumpenports (21) über ein zweites Ventil (19) unmittelbar an die Präparatkammer (1) angeflanscht. Der Ansaugstutzen des Drag-Stufen Ports (22) der ersten Turbomolekularpumpe (14) ist weiterhin an den Auslaß der zweiten Turbomolekularpumpe (13) angeschlossen, so daß die erste Turbomolekularpumpe (14) zusätzlich zur Evakuierung des der Probenkammer (1) benachbarten Zwischendruckbereiches (8) zum Vorpumpen der zweiten Turbomolekularpumpe (13) über den Drag-Stufen Port (22) dient. Der Ansaugstutzen (23) der zweiten Turbomolekularpumpe (13) ist an den zum Ultrahochvakuumbereich (6) benachbarten Zwischendruckbereich (7) direkt angeschlossen.

Soweit vorstehend oder nachfolgend von einem direkten Anschluß einer Vakuumpumpe an einen Druckbereich gesprochen ist, ist damit gemeint, daß die durch diese Pumpe erfolgende Evakuierung des betreffenden Druckbereiches direkt erfolgt, also ohne daß die von dieser Pumpe abgepumpten Gasmoleküle zwischen dem betreffenden Druckbereich und dem Ansaugstutzen der Pumpe eine Druckstufenblende passieren müssen.

Das vorstehend beschriebene Vakuumsystem ist ein differentiell gepumptes Vakuumsystem mit insgesamt vier Druckbereichen.

Mit der beschriebenen kaskadenförmigen, seriell geschalteten Pumpanordnung läßt sich mit Hilfe einer einzigen Ionengetterpumpe (12), den zwei Turbomolekularpumpen (13), (14) und einer einzigen Vorpumpe (16) ein Ultrahochvakuum mit Drücken kleiner 5 x 10⁻⁸ hPa in der Ultrahochvakuumkammer (6) bei Drücken zwischen 5 hPa und 10⁻⁷ hPa in der Präparatkammer (1) aufrechterhalten. Bei gewünschten Drücken in der Präparatkammer (1) zwischen 10⁻² hPa und 5 hPa ist dabei das Ventil (17) zwischen der Vorpumpe (16) und der Präparatkammer (1) geöffnet und das zweite Ventil (19) zwischen der ersten Turbomolekularpumpe (14) und der Präparatkammer (1) geschlossen. Das Vakuum in der Präparatkammer (1) ist dann ausschließlich durch das mit der Vorpumpe (16) erreichbare bzw. an dieser eingeregelte Vakuum bestimmt. Durch das Vorpumpen des Auslasses (26) der zweiten Turbomolekularpumpe durch das Vorvakuum der Drag-Stufe (24) der ersten Turbomolekularpumpe (14) und dadurch, daß die nahezu komplette Pumpleistung der ersten Turbomolekularpumpe (14) ausschließlich zum Pumpen des der Präparatkammer benachbarten Zwischendruckbereiches (8) dient, wird sicher gestellt, daß in dem dem Ultrahochvakuumbereich benachbarten Zwischendruckbereich (7) ein Vakuum zwischen 10⁻⁴ und 10⁻⁶ hPa aufrechterhalten wird.

Bei Drücken unter 10⁻² hPa in der Präparatkammer (1), die mit der Vorpumpe (16) nicht erreichbar sind, wird das erste Ventil (17) zwischen der Vorpumpe (16) und der Präparatkammer (1) geschlossen und das zweite Ventil (19) zwischen der Präparatkammer (1) und der ersten Turbomolekularpumpe (14) geöffnet. Die Vorpumpe (16) dient dann ausschließlich zum Vorpumpen der ersten Turbomolekularpumpe (14). Sowohl die Präparatkammer (1) als auch der der Präparatkammer (1) benachbarte Zwischendruckbereich (8) werden dann durch die erste Turbomolekularpumpe (14) direkt gepumpt. Die in der Objektivlinse (4) angeordnete Druckstufenblende (11) ist in diesem Fall ohne Wirkung. Durch die mit der ersten Turbomolekularpumpe (14) vorgepumpte zweite Turbomolekularpumpe (13) wird auch in diesem Fall in dem dem Ultrahochvakuumbereich (6) benachbarten Zwischendruckbereich (7) ein Vakuum zwischen 10⁻⁴ und 10⁻⁶ hPa aufrechterhalten.

In beiden Fällen liegt das Vorvakuum der Drag-Stufe (24) der ersten Turbomolekularpumpe, durch das die zweite Turbomolekularpumpe (13) vorgepumpt wird, in einem Bereich zwischen 10⁻¹ hPa und 10⁻⁴ hPa.

Damit bei dem beschriebenen Ausführungsbeispiel auch beim Öffnen der Präparatkammer (1) das Ultrahochvakuum im Ultrahochvakuumbereich (6) aufrechterhalten wird, ist innerhalb der elektronenoptischen Säule, vorzugsweise zwischen dem Ultrahochvakuumbereich und dem dem Ultrahochvakuumbereich benachbarten Druckbereich (7) ein Absperrventil (18) vorgesehen, das vor dem Öffnen der Präparatkammer (1) geschlossen wird. Die Vorpumpe (16) und die beiden Turbomolekularpumpen (13), (14) können dadurch beim Öffnen der Präparatkammer (1) außer Betrieb gesetzt werden.

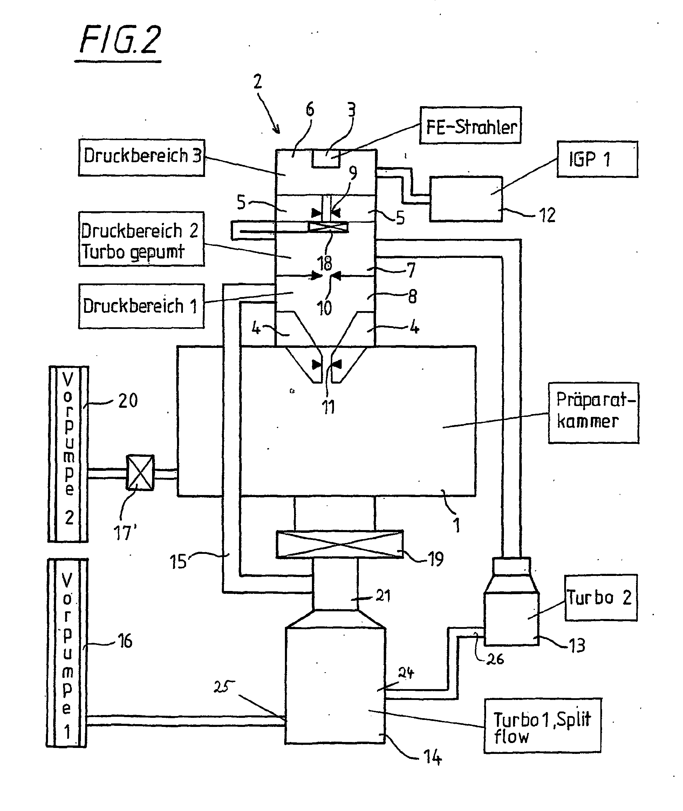

Das in der Figur 2 dargestellte Ausführungsbeispiel entspricht im wesentlichen dem Ausführungsbeispiel in Figur 1. Demzufolge sind in der Figur 2 diejenigen Komponenten, die denen des Ausführungsbeispiels nach Figur 1 entsprechen, mit identischen Bezugszeichen versehen. Soweit beide Ausführungsbeispiele übereinstimmen, wird bzgl. Figur 2 auf die vorstehende Beschreibung der Figur 1 verwiesen.

Der wesentliche Unterschied zwischen dem Ausführungsbeispiel nach Figur 2 und dem nach Figur 1 besteht darin, daß die Vorpumpe (16) beim Ausführungsbeispiel nach Figur 2 ausschließlich zum Vorpumpen der ersten Turbomolekularpumpe (14) dient, deren vorvakuumseitige Dragstufe (24) wiederum zum Vorpumpen der zweiten Turbomolekularpumpe (13) dient. Zum Evakuieren der Präparatkammer (1) ist eine zweite Vorpumpe (20) vorgesehen, deren Pumpleistung wiederum über ein erstes Ventil (17') regelbar ist. Mit dieser alternativen Pumpenanordnung mit einer zweiten Vorpumpe (20) ist das Teilchenstrahlgerät unter Aufrechterhaltung des Ultrahochvakuums im Ultrahochvakuumbereich (6) auch bei Drücken in der Präparatkammer bis 100 hPa einsetzbar. Bei Kammerdrücken unter 10⁻² hPa in der Präparatkammer (1) wird sowohl die Präparatkammer (1) als auch der der Präparatkammer (1) benachbarte Zwischendruckbereich (8) ausschließlich über die erste Turbomolekularpumpe gepumpt. In diesem Fall ist das erste Ventil (17') zwischen der zweiten Vorpumpe (20) und der Präparatkammer (1) geschlossen und das zweite Ventil (19) zwischen der ersten Turbomolekularpumpe (14) und der Präparatkammer (1) geöffnet. Bei Drücken zwischen 10⁻² und 100 hPa ist demhingegen das erste Ventil (17') geöffnet, so daß die Präparatkammer (1) durch die zweite Vorpumpe (20) evakuiert wird, und das zweite Ventil (19) geschlossen. Der aufgrund der höheren Kammerdrücke stärkere Gasstrom zwischen der Präparatkammer und der der Präparatkammer (1) benachbarten Zwischendruckkammer (8) wird bei diesem Ausführungsbeispiel dadurch abgefangen, daß die erste Vorpumpe (16) ausschließlich zum Vorpumpen der ersten Turbomölekularpumpe (14) dient, die dadurch eine entsprechend erhöhte Förderleistung erhält. Auch in diesem Fall gewährleistet die durch die Drag-Stufe (24) der ersten Turbomolekularpumpe (14) mit einem Vorvakuum im Bereich zwischen 10⁻¹ hPa und 10⁻⁴ hPa vorgepumpte zweite Turbomolekularpumpe (13) die Aufrechterhaltung eines Vakuums zwischen 10⁻⁵ und 10⁻⁶ hPa in dem an den Ultrahochvakuumbereich (6) angrenzenden Zwischendruckbereich (7).

Bei dem in der Figur 2 dargestellten Ausführungsbeispiel wird zwischen dem Ultrahochvakuumbereich (6) und der Präparatkammer eine Druckdifferenz von bis zu 10 Größenodnungen, also von 10¹⁰ hPa über nur zwei Zwischendruckbereiche aufrecht erhalten.

Grundsätzlich denkbar wäre es auch, wie beim zitierten Stand der Technik, auch den an den Ultrahochvakuumbereich angrenzenden Zwischendruckbereich (7) mittels einer zweiten Ionengetterpumpe zu evakuieren. In diesem Fall wäre dann der an die Präparatkammer (1) angrenzende Zwischendruckbereich mittels einer durch die Drag-Stufe einer Turbomolekularpumpe vorgepumpten Turbomolekularpumpen zu evakuieren. Die zweite Ionengetterpumpe müßte dann jedoch mit sehr hoher Pumpleistung ausgelegt sein, wodurch wiederum wegen der größeren Abmessungen der Ionengetterpumpe eine größere Bauhöhe der elektronenoptischen Säule resultieren würde.

## Patentansprüche

1. Kaskadenförmige Pumpanordnung für ein Teilchenstrahlgerät mit einer ersten und einer zweiten Turbomolekularpumpe (13, 14), wobei der Auslaß (26) der zweiten Turbomolekularpumpe (13) so angeordnet ist, dass er im Betrieb durch einen zwischen dem Haupt-Pumpenport (21)und dem Auslaß (25) der ersten Turbomolekularpumpe (14) liegenden Zwischendruckbereich (24) vorgepumpt wird.

2. Kaskadenförmige Pumpanordnung nach Anspruch 1, wobei die erste Turbomolekularpumpe (14) eine Split-Flow-Pumpe mit einem Anschlußstutzen (22) an der Drag-Stufe (24) ist und der Auslaß (26) der zweiten Turbomolekularpumpe (13) an die Drag-Stufe (24) der ersten Turbomolekularpumpe (14) angeschlossen ist.

3. Pumpenanordnung nach Anspruch 1 oder 2, wobei eine weitere Vorpumpe (16) zum Vorpumpen des Auslasses (25) der ersten Turbomolekularpumpe (14) vorhanden ist.

4. Teilchenstrahlgerät, das eine im Ultrahochvakuum zu betreibende Teilchenquelle (3) und eine Präparatkammer (1) aufweist, die mit Drücken vom Hochvakuum mindestens bis zu 1 hPa betreibbar ist, und wobei eine kaskadenförmige Pumpanordnung nach einem der Ansprüche 1 - 3, vorhanden ist.

5. Teilchenstrahlgerät nach Anspruch 4, wobei zwischen dem Ultrahochvakuumbereich (6) der Teilchenquelle und der Probenkammer (1) genau zwei weitere Zwischendruckbereiche (7), (8) vorhanden sind.

6. Teilchenstrahlgerät nach einem der Ansprüche 4 - 5, wobei der dem Ultrahochvakuumbereich (6) benachbarte Druckbereich im Betrieb mittels der zweiten Turbomolekularpumpe (13) gepumpt wird.

7. Teilchenstrahlgerät nach einem der Ansprüche 4 - 6, wobei die erste Turbomolekularpumpe (14) über den Haupt-Pumpenport (21) gleichzeitig direkt an den der Präparatkammer (1) benachbarten Druckbereich (8) angeschlossen ist.

8. Teilchenstrahlgerät nach Anspruch 7, wobei die Vorpumpe (16) über ein Ventil (17) direkt an die Präparatkammer (1) angeschlossen ist.

9. Teilchenstrahlgerät nach einem der Ansprüche 4 bis 8, wobei die erste Turbomolekularpumpe (14) zusätzlich über ein weiteres Ventil (19) direkt an die Präparatkammer (1) angeschlossen ist.

10. Teilchenstrahlgerät nach einem der Ansprüche 8 - 9, wobei eine zweite Vorpumpe (20) vorgesehen und an die Präparatkammer (1) angeschlossen ist.

11. Teilchenstrahlgerät nach einem der Ansprüche 4 bis 10, wobei eine Ionengetterpumpe (12) zum Evakuieren des Ultrahochvakuumbereiches (6) vorhanden ist.

## Claims

1. Cascade-type pump arrangement for a particle beam device, having a first and a second turbomolecular pump (13, 14), wherein the outlet (26) of the second turbomolecular pump (13) is arranged in such a way that it is backed when in operation by an intermediate pressure region located between the main pump port (21) and the outlet (25) of the first turbomolecular pump (14).

2. Cascade-type pump arrangement according to Claim 1, wherein the first turbomolecular pump (14) is a split-flow pump with a connector (22) at the drag stage (24) and the outlet (26) of the second turbomolecular pump (13) is connected to the drag stage (24) of the first turbomolecular pump (14).

3. Pump arrangement according to Claim 1 or 2, wherein a further backing pump (16) is present for backing the outlet (25) of the first turbomolecular pump (14).

4. Particle beam device, which comprises a particle source (3) for operation under ultra-high vacuum and a preparation chamber (1), which is operable with high vacuum pressures of at least up to 1 hPa, and wherein a cascade-type pump arrangement according to one of Claims 1 to 3 is present.

5. Particle beam device according to Claim 4, wherein precisely two further intermediate pressure regions (7, 8) are present between the ultra-high vacuum region (6) of the particle source and the specimen chamber (1).

6. Particle beam device according to one of Claims 4 to 5, wherein the pressure region adjacent the ultra-high vacuum region (6) is pumped by means of the second turbomolecular pump (13) when in operation.

7. Particle beam device according to one of Claims 4 to 6, wherein the first turbomolecular pump (14) is connected via the main pump port (21) at the same time directly to the pressure region (8) adjacent the preparation chamber (1).

8. Particle beam device according to Claim 7, wherein the backing pump (16) is connected via a valve (17) directly to the preparation chamber (1).

9. Particle beam device according to one of Claims 4 to 8, wherein the first turbomolecular pump (14) is additionally connected via a further valve (19) directly to the preparation chamber (1).

10. Particle beam device according to one of Claims 8 to 9, wherein a second backing pump (20) is provided and connected to the preparation chamber (1).

11. Particle beam device according to one of Claims 4 to 10, wherein an ion getter pump (12) is present for evacuating the ultra-high vacuum region (6).

## Revendications

1. Système de pompes en cascade pour appareil à faisceau de particules, qui présente une première et une deuxième turbopompe moléculaire (13, 14), la sortie (26) de la deuxième turbopompe moléculaire (13) étant disposée de telle sorte qu'en fonctionnement, la zone (24) à pression intermédiaire située entre l'orifice principal de pompe (21) et la sortie (25) de la première turbopompe moléculaire (14) est pré-pompée.

2. Système de pompes en cascade selon la revendication 1, dans lequel la première turbopompe moléculaire (14) est une pompe à division d'écoulement dotée d'une tubulure de raccordement (22) sur l'étage d'aspiration (24), la sortie (26) de la deuxième turbopompe moléculaire (13) étant raccordée à l'étage de d'aspiration (24) de la première turbopompe moléculaire (14).

3. Système de pompes selon les revendications 1 ou 2, qui présente une autre pré-pompe (16) de pré-pompage de la sortie (25) de la première turbopompe moléculaire (14).

4. Appareil à faisceaux de particules qui présente une source de particules (3) qui est destinée à fonctionner sous un vide ultra-poussé et une chambre (1) à préparations qui peut fonctionner à des pressions qui vont d'un vide poussé à au moins 1 hPa, et qui présente un système de pompes en cascade selon l'une des revendications 1 à 3.

5. Appareil à faisceaux de particules selon la revendication 4, qui présente exactement deux autres zones (7), (8) à pression intermédiaire entre la zone à vide ultra-poussé (6) de la source de particules et la chambre (1) à échantillons.

6. Appareil à faisceaux de particules selon l'une des revendications 4-5, dans lequel en fonctionnement, la zone de pression voisine de la zone (6) à vide ultra-poussé est pompée au moyen de la deuxième turbopompe moléculaire (13).

7. Appareil à faisceaux de particules selon l'une des revendications 4 à 6, dans lequel la première turbopompe moléculaire (14) est en même temps raccordée par l'intermédiaire de l'orifice principal de pompe (21) directement à la zone (8) sous pression voisine de la chambre (1) à préparations.

8. Appareil à faisceaux de particules selon la revendication 7, dans lequel la pré-pompe (16) est raccordée directement à la chambre (1) à préparations par l'intermédiaire d'une soupape (17).

9. Appareil à faisceaux de particules selon l'une des revendications 4 à 8, dans lequel la première turbopompe moléculaire (14) est de plus raccordée directement à la chambre (1) à préparations par l'intermédiaire d'une autre soupape (19).

10. Appareil à faisceaux de particules selon l'une des revendications 8 à 9, dans lequel une deuxième pré-pompe (20) est prévue et est raccordée à la chambre (1) à préparations.

11. Appareil à faisceaux de particules selon l'une des revendications 4 à 10, qui présente une pompe (12) à absorbeur d'ions pour mettre la zone (6) sous vide ultra-poussé.
